# EUROPEAN PATENT APPLICATION

(11) **EP 0 789 248 A2**
(43) Date of publication of application: **13.08.1997**
(21) Application number: 97830043.2
(22) Date of filing: 07.02.1997
(51) Int. Cl.: G01R 31/12

(54) **Method of and apparatus for monitoring and testing the insulation of electrical components**

(30) Priority: 08.02.1996 IT RM960086
(71) Applicant: ABB Muratori Spa, 00040 Ariccia (Roma) (IT)
(72) Inventor: Sacerdoti, Giancarlo, 00144 Roma (IT)
(74) Representative: Sarpi, Maurizio

(57) **Abstract**

A method of monitoring and testing the insulation quality of electrical components, comprising the steps of: instructing the system on the characteristics of the individual monitored component; sampling the incoming signal from the monitored component at a predetermined sampling frequency f_{c}, and storing N sampling readouts after analogue/digital conversion to binary (0, 1) or ternary (0, 1, -1) digits; statistically or pseudo statistically processing the N binary/ternary sampling readouts to provide the characterizing parameters of the monitored insulation failure class by hardware or software techniques; comparing the thus obtained parameters with those of the typical signals stored during the first instruction step. The invention also provides an apparatus for carrying out the method.

## Description

The present invention relates to apparatuses and systems for monitoring the insulation quality of electrical components such as cables, transformers, capacitors, etc.

As known, in the a.c. apparatuses such as middle and high voltage cables and capacitors the insulators are subjected to high electrical fields at times with double as high frequency as that of the voltage of the electrical circuit to which such components are connected. Therefore, the latter often break down because of disruptive electrical discharge.
Therefore, in the well-established practice of the industry it is useful to arrange a monitoring system operating continuously or at fixed times which indicates the insulator state of deterioration and gives a measure of its reliability by storing and analysing the noise of different nature, for example due to vibrations or electromagnetic fields, generated first of all by microdischarges and then by discharges in the insulator.
In order to carry out such monitoring the theory of the discharges in the gas, liquid and solid dielectric is particularly effective as it allows the characteristics of the signals generated by the monitored component to be detected as far as the insulation quality is concerned. Monitoring and testing the insulation quality of the electrical components can be carried out by using apparatuses including generally a sensor which detects the signals to be monitored and supplies them under analogue form to an analogue-digital converter which converts the signal to digital form. The digitalized signals of the converter are suitably processed and the processed signals are displayed and fed to control devices. There is also provided an "instruction device" for teaching the system to grade the quality of the monitored component according to criteria established for any individual application.
According to typically implemented methods the analogue signal is sampled at a sampling frequency f_{c} determined by the maximum frequency of the signal which is being converted into binary digits in order to achieve reliability and sensitivity predetermined by a suitable choice of the bit number for any detected analogue signal.
The signal is processed off-line or on-line and such a processing is limited most times to the provision of conventional Fourier spectra of the signal after a suitable division into time segments of different lengths equal to fractions of the supply voltage period.
However, the known methods and apparatuses have considerable limitations regarding cost and speed of response because of the rather complicated procedures of storing and processing the signal.
Particularly, the known signal detection systems need a rather large memory in which the digitalized signals to be thereafter processed are stored. Such even satisfying procedures can be effectively replaced by the method of the present invention which is of the statistical type, thus requiring a high number of samplings. However, such samplings formed of binary or ternary digits need less memory and are easily processed.

The present invention seeks to provide simplified solutions for a detection, storage and processing system which are particularly suitable in case the monitoring of an electrical component, which may last several hours without substantially modifying the insulation quality, is carried out by means of a number of samplings which is sufficient for using statistical methods allowing the insulation quality to be tested with high reliability. Such a method is called in the present description S.I.Q.C (Statistical Insulation Quality Characterization).

To this purpose the present invention provides a method of monitoring and testing the insulation of an electrical component, comprising the following steps:
- instructing the system on the characteristics of the individual monitored component by detecting and storing typical signals corresponding to different insulation qualities or failure classes;
- sampling the signal from the monitored component at a predetermined sampling frequency f_{c}, and storing N samplings after statistical analogue/digital conversion to binary (0, 1) or ternary (0, 1, -1) digits;
- statistically processing the N binary/ternary sampling strings of length n (n = 1, 2,..., n) to provide the characterizing parameters of the monitored insulation failure class;
- comparing the thus obtained parameters with those of the typical signals stored during the first instruction step.

According to the invention there is also provided an apparatus for carrying out said method comprising a sensor capable of detecting the (vibrational, acoustic, optical or electromagnetic) noise from the monitored component and supplying it to a binary or ternary A/D amplitude-time converter of the N samplings at a clock frequency not very different from the clock frequency defining the sampling frequency. The N samplings are then processed by known techniques in order to provide the diagrams and the characteristic parameters of the insulation quality. Such parameters are compared with those of the typical signals stored in an instruction device previously used for detecting the particular component to be monitored.

The achieved advantages consist essentially in that the signal detection, storage and processing system is markedly simplified by carrying out a monitoring based upon as long time (a few minutes to several hours) as the characteristics of the failures are become stable, thus achieving a processing method of the statistical type which is very easy and reliable as far as the calculation is concerned.
A second advantage is that the apparatus for carrying out the method of the invention is cheap and easily assemblable.

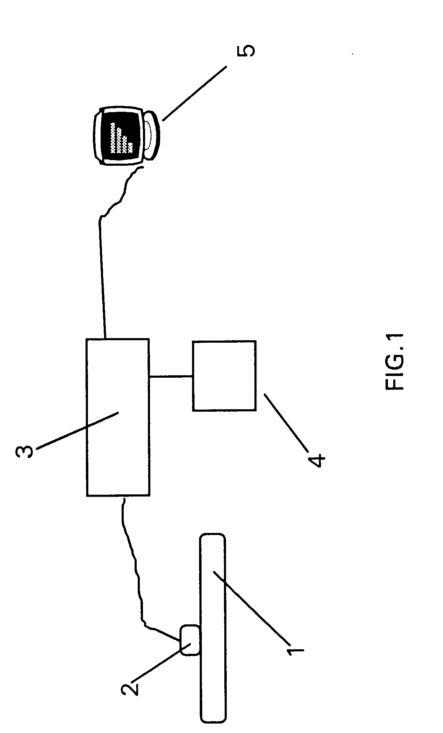

These and further advantages will be more readily understood by those skilled in the art from the following not limiting description and the accompanying drawing in which Fig. 1 shows a block diagram of the apparatus according to the invention.

In a preferred embodiment of the method according to the invention the signal is sampled at frequencies up to some hundreds of kHz and higher for even long time (several hours) . In the described instance, the analogue/digital conversion is carried out by means of a binary amplitude-time converter giving a readout of 1 or 0 if the clock of the readout counter has a frequency other than f_{c} but between f_{c} and 2 f_{c}.
Advantageously, according to the invention, because of the great number of samplings (for instance, about 7x10⁸ binary readouts can be stored in one hour) statistical techniques known per se can be implemented by means of a computer for analysing and characterizing the signals. Such techniques are developed by easily storing the number of events in which a 1 is detected, the number of events in which the sum of two samplings in succession is equal to 0 or 1 or 2 and so on until the statistics of the sum s_{N} of N readouts of 1 in succession is obtained.
For example, in case the mains voltage has a frequency of 50 Hz, the curves P^{N} (s_{N}), N being 100 to 400, characterize thoroughly the insulation quality and the probability P in which a particular succession of 1 and 0 occurs. Such curves further allow the Markovian model of the source of discharges excited by sinusoidal voltage to be provided by means of known mathematical methods. Once the Markovian model and the probability factors are known, the quality of the source is obtained.
More generally, once N binary digits are stored by the described method, the same are processed by implementing a number of known techniques so as to characterize thoroughly the quality of the monitored insulation. It is particularly possible:
a) providing the Fourier spectrum of the time successions of 0 and 1 stored in a period of time;
b) providing the frequency P₁ of bits 1, the frequency of the mean values of a bit in a string of two bits (0, 1, 2), the frequency of 1 in a string of k bits (0, 1,..., k), etc.;
c) providing the Fourier spectrum of the time successions of the s_{N} values (sum of 1) stored in the successions of strings of N events;
d) providing the spectrum of P^{s}ₖ/P^{s}₁ = p^{s}ₖ in strings of s (for instance 200) elements, k being the occurrence of k values of 1 (such parameter makes the result independent of the sensitivity of the sensor), and P^{s}ₖ varying as the value Vₘₐₓ (maximum value of the excitation voltage) changes;
e) providing the Markovian model of the noise source.
All of the above result representation forms (Markovian model, Fourier spectra, factors p^{s}ₖ) are correlated to the insulation class or quality of the monitored component.
Once the incoming signal is stored and processed, the obtained curves and results are compared with those of the typical signals stored in the preliminary apparatus instruction step and representing the different insulation failure conditions which may change according to circumstances (cables, impregnated paper capacitors, polyvinyl capacitors, etc.).
Finally, it should be pointed out that the described method is the same also in case the sign is discriminated by storing three different signals 1, 0, -1 (ternary storage).

Referring now to Fig. 1 a preferred embodiment of an apparatus according to the invention includes a sensor 2 capable of detecting a vibrational, acoustic, optical or electromagnetic signal from a component 1 to be monitored and supplying it to a transducer 3 for storage purpose.
In the described embodiment transducer 3 is a binary amplitude-time converter provided with a clock having a frequency near the signal sampling frequency f_{c}, preferably between f_{c} and 2 f_{c}.
Upon sampling, transducer 3 receives an analogue signal and, upon receiving a clock signal, stores a digit which in case of binary transmission may be a bit 1 or 0. At the end of the detection period which may last as long as the insulation quality may be kept constant, transducer 3 has stored a number N of binary readouts such as to allow statistical methods to be implemented. The stored binary signal is processed by hardware or software techniques of known type, as mentioned above. The processing results, which may be different according to the implemented technique and the particular application, are compared with the typical signals stored in an instruction device 4 and corresponding to possible different failure conditions of the monitored component.
At last, the final processing result of the comparison with the typical signals can be displayed on a display 5 connected to the output of transducer 3.
The present invention is described with reference to a preferred embodiment thereof, however, it should be understood that modifications may be made by those skilled in the art without departing from the scope of the present industrial invention.

## Claims

1. A method of monitoring and testing the insulation quality of electrical components, comprising the following steps:
- instructing the system on the characteristics of the individual monitored component by detecting and storing typical signals corresponding to different insulation qualities or failure classes;
- sampling the incoming vibrational, acoustic, optical or electromagnetic signal from the monitored component at a predetermined sampling frequency f_{c}, and storing N sampling readouts after analogue/digital conversion to binary (0, 1) or ternary (0, 1, -1) digits, N being a number sufficient for statistical applications;
- statistically or pseudo statistically processing the N binary/ternary sampling readouts to provide the characterizing parameters of the monitored insulation failure class by hardware or software techniques;
- comparing the thus obtained parameters with those of the typical signals stored during the first instruction step.

2. The method according to claim 1, characterized in that said storing step is carried out by a binary or ternary A/D amplitude-time transducer provided with a clock having a frequency near the sampling frequency f_{c}.

3. The method according to claims 1 and 2, characterized in that said clock frequency of the transducer is f_{c} to 2f_{c}.

4. The method according to the preceding claims, characterized in that said processing step provides one or more of the following signal processing techniques:
a) providing the Fourier spectrum of the stored signals in the whole storage time;
b) providing the frequency P₁ of bits 1, the frequency of the mean values of a bit in a string of two bits (0, 1, 2), the frequency of 1 in a string of k bits (0, 1,..., k), etc.;
c) providing the Fourier spectrum of the bits in the strings in succession of predetermined length;
d) providing the spectrum of P^{s}ₖ/P^{s}₁ = P^{s}ₖ in strings of s elements, k being the occurrence of k values of 1, and P^{s}ₖ varying as the maximum value of the excitation voltage Vₘₐₓ changes;
e) providing the Markovian model of the noise source.

5. The method according to the preceding claims, characterized in that said sampling and storing steps are extended as long as the insulation quality of the monitored component remains essentially stable.

6. The method according to the preceding claims, characterized in that there is further provided a final step of displaying the results of said comparing step.

7. An apparatus for monitoring and testing the insulation of electrical components, characterized by a sensor (2) capable of detecting a vibrational, acoustic, optical or electromagnetic signal from the monitored component (1) and supplying it to a binary or ternary A/D amplitude-time converter (3) for sampling the incoming signal at a frequency f_{c} and storing N binary or ternary readouts, said stored signals being then processed by statistical hardware or software techniques by a microprocessor device and compared with typical signals previously stored in an instruction device (4) and corresponding to possible different failure conditions of the monitored component.

8. The apparatus of claim 7, characterized in that said transducer is a binary or ternary A/D amplitude-time converter.

9. The apparatus of claims 7 and 8, characterized in that the clock frequency of the readout counter of said transducer (3) is near the sampling frequency f_{c} of the incoming signal, preferably f_{c} to 2f_{c}.

10. The apparatus of claims 7 to 9, characterized in that there is further provided a display (5) connected to the output of said transducer (3) for displaying the results of processing and comparing the incoming signals with said typical signals.
